# EUROPEAN PATENT SPECIFICATION

(11) **EP 2 709 235 B1**
(45) Date of publication and mention of the grant of the patent: **15.04.2020**
(21) Application number: 13183309.7
(22) Date of filing: 06.09.2013
(51) Int. Cl.: H02J 7/00, G01R 31/36

(54) **Battery state indication device and electric construction tool**
Vorrichtung zur Anzeige des Batteriezustands und elektrisches Bauwerkzeug
Dispositif d'indication d'état de batterie et outil de construction électrique

(30) Priority: 13.09.2012 JP 2012201424
(43) Date of publication of application: 19.03.2014
(73) Proprietor: Panasonic Intellectual Property Management Co., Ltd., Osaka-shi, Osaka 540-6207 (JP)
(72) Inventor: Okada, Masaaki, Chuo-ku, Osaka 540-6207 (JP); Ikeda, Masaki, Chuo-ku, Osaka 540-6207 (JP)
(74) Representative: Appelt, Christian W.

(56) References cited:
- DE-A1- 4 204 420
- JP-B- 3 366 568
- US-A1- 2008 290 835
- US-A1- 2009 080 987
- US-A9- 2005 258 801
- US-B1- 6 529 840

## Description

The present invention relates to a battery state indication device and an electric construction tool.

A known electric construction tool performs over-discharge prevention control so that multiple types of battery packs having different voltages may selectively be attached to the electric construction tool (refer to International Publication No. WO 2011/118475).

A further known electric construction tool includes a battery state indication device that indicates (displays) the voltage state (state of charge) of the battery pack attached to the electric construction tool (refer to Japanese Laid-Open Patent Publication No. 2010-170779).

The battery state indication device of the electric construction tool described in Japanese Laid-Open Patent Publication No. 2010-170779 indicates the state of charge for the same battery pack. Thus, the battery state indication device cannot correctly indicate the voltage state of the battery pack when different types of battery packs are selectively attached to the electric construction tool such as in International Publication No. WO 2011/118475.

Document JP-3 366568 B discloses a battery charging device, which determines the necessity of a refreshment treatment for a battery based on the information stored in a memory. The information corresponds to the repeated number of charging, the charged voltage in the last use and a characteristics table of temperatures to charged voltages.

Document US 2005/0258801 A9 describes a system and a method for battery protection. In some aspects, a method of conducting an operation including a battery pack, includes the acts of monitoring a first battery pack condition at a first monitoring rate, determining when a second battery pack condition reaches a threshold, after the second battery pack condition reaches the threshold, monitoring the first battery pack condition at a second monitoring rate, the second monitoring rate being different than the first monitoring rate.; In some aspects, a method of conducting an operation including a battery, the battery including a cell having a voltage, power being transferable between the cell and the electrical device, a controller operable to control a function of the battery pack, the controller being operable with a voltage at least one of equal to and greater than an operating voltage threshold, the cell being operable to selectively supply voltage to the controller, includes the act of enabling the controller to operate when the voltage supplied by the cell is below the operating voltage threshold.

US 2008/0290835 A1 describes a charging device capable of appropriately grasping the charged state of a battery pack using data stored in a memory of the battery pack even when the battery pack becomes commercial as a new product. A charging device determines charged state data indicative of a charged state of a battery pack mounted thereon based on a charging current supplied and/or a charging voltage applied to the battery pack. A charge control microcomputer reads charging characteristics data from a memory of the battery pack, and generates a data table associating at least one of the charging current supplied and the charging voltage applied to the battery pack and the charged state data with each other, based on the charging characteristics data read out. The microcomputer determines charged state data indicative of a charged state of the battery pack, based on the generated data table.

DE 42 04 420 A1 describes an electric screwdriver having a motor housing with a pistol-type hand grip and finger-operated trigger. At the rear is fastened a battery pack with a meter with LCD display to indicate the state of charge. The meter is a module interposed between housing and battery pack and is detachable, the connections being small lugs. These lugs provide the electrical connection between battery pack and the motor. For recharging, the battery pack and meter unit are detached as a block and clipped into a battery charger.

It is an object of the present invention to provide an electric construction tool comprising a battery state indication device that correctly indicates the state of charge of a battery pack even when multiples types of batteries are selectively attached, and to provide an electric construction tool including such a battery state indication device.

The invention relates to an electric construction tool as defined by independent claim 1. The electric construction tool comprises:
a battery state indication device;
characterized in that the battery state indication device comprises:
   a voltage measurement unit configured to measure a voltage of one of a plurality of battery packs that is connected to the battery state indication device, wherein the battery state indication device is selectively connectable to the plurality of battery packs configured to have different rated output voltages;
   a battery identification unit configured to identify the one of the battery packs connected to the battery state indication device;
   a threshold memory configured to store a plurality of voltage thresholds respectively corresponding to the rated output voltages of the battery packs, wherein the rated output voltage of each of the battery packs is defined in accordance with the total number of series-connected cells included in the respective battery pack and the voltage per cell;
   a control unit configured to read the voltage thresholds corresponding to the rated output voltage of the battery pack identified by the battery identification unit and configured to compare the voltage of the battery pack measured by the voltage measurement unit with the voltage thresholds corresponding to the identified battery pack to determine a state of charge of the battery pack; and
   an indicator configured to indicate the state of charge of the battery pack determined by the control unit,
   wherein the indicator includes a plurality of state of charge marks; and
   in accordance with the state of charge of the battery pack determined by the control unit, the indicator is configured to indicate the state of charge of the battery pack in a stepped manner with the state of charge marks,
   wherein the state of charge marks include a plurality of LEDs; and
   the control unit is configured to determine the number of LEDs that are illuminated based on the comparison of the measured voltage of the battery pack with the voltage thresholds, and
   wherein the control unit is further configured to receive a signal indicating information on the rated output voltage from the battery pack and determine whether or not the battery pack is a battery pack applicable to the electric construction tool based on the received signal.

The present invention provides an electric construction tool that correctly indicates the state of charge of a battery pack even when multiples types of batteries having different voltages are selectively attached.

Other objects and advantages of the present invention will become apparent from the following description, taken in conjunction with the accompanying drawings, illustrating by way of example the principles of the present disclosure.

The invention, together with objects and advantages thereof, may best be understood by reference to the following description together with the accompanying drawings in which:
Fig. 1 is a schematic diagram of a power tool according to the present disclosure;
Fig. 2 is a graph showing the relationship between the state of charge and the voltage for different battery packs;
Fig. 3 is a schematic diagram showing one example of a voltage indicator; and
Fig. 4 is a diagram illustrating the operation of the voltage indicator in the power tool.

A power tool according to the present disclosure will now be described with reference to the drawings.

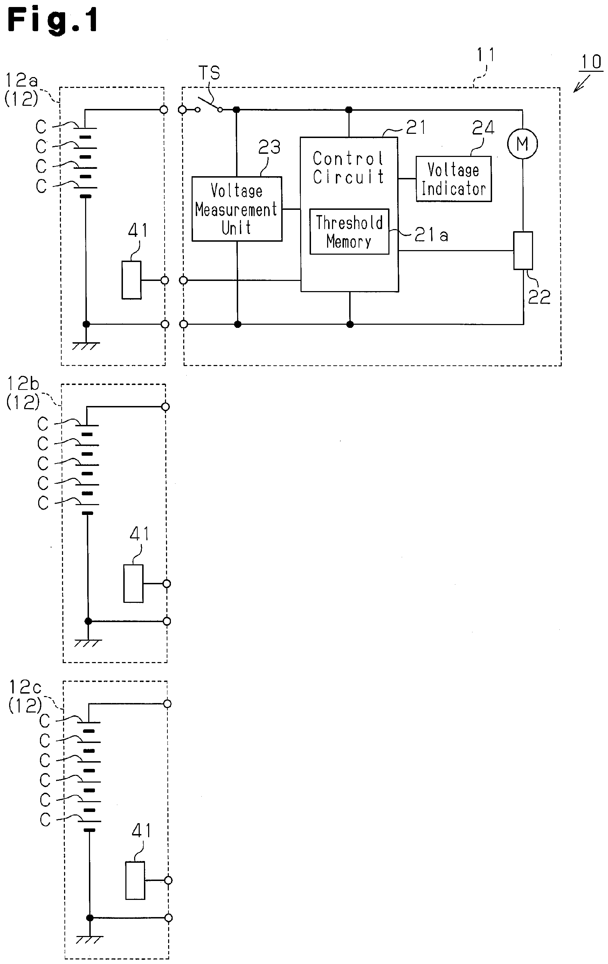

Referring to Fig. 1, the power tool 10 includes a main body 11 and a battery pack 12. The main body 11 includes a motor M, and the battery pack 12 is attached in a removable manner to the main body 11.

The main body 11 of the power tool 10 includes a motor M, a control circuit 21, and a driver 22. The control circuit 21 communicates with the battery pack 12 and drives and controls the main body 11. The driver 22 is electrically connected to the control circuit 21 and controls the rotation speed of the motor M.

The control circuit 21 is formed by a microcomputer or the like and controls the motor M with the driver 22 in accordance with the movement of a trigger switch TS operated by a user. The trigger switch TS is coupled to and exposed from the main body 11 so as to allow for a user to operate the trigger switch TS. As shown in Fig. 1, the driver 22, which is connected to the control circuit 21, controls the rotation speed of the motor M. The driver 22 controls the rotation produced by the motor M by performing pulse width modulation (PWM) control that activates and deactivates a switching element (not shown) in accordance with a signal supplied from the control circuit 21.

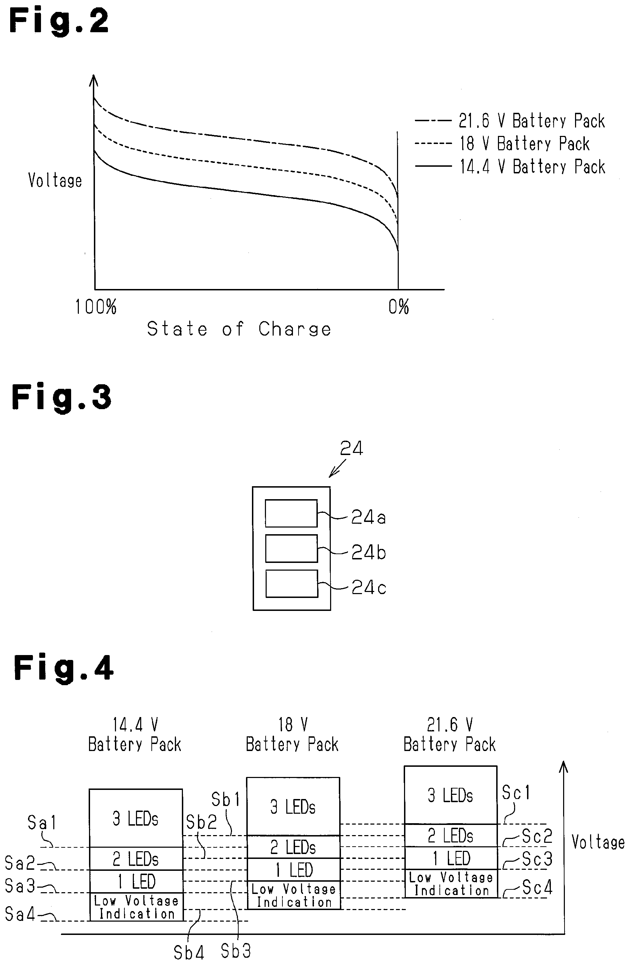

The battery pack 12 applicable to the main body 11 has a predetermined rated output voltage. Fig. 1 shows a plurality of battery packs 12, namely, battery packs 12a, 12b, and 12c, which are lithium-ion batteries. The output voltage per cell C is approximately 3.6 V. The number of cells C included in each battery pack 12 determines the rated output voltage of the battery pack 12. For example, the battery pack 12a, which includes four series-connected cells C, has a rated output voltage of 14.4 V. The battery pack 12b, which includes five series-connected cells C, has a rated output voltage of 18 V. The battery pack 12c, which includes six series-connected cells C, has a rated output voltage of 21.6 V. Further, as shown in Fig. 2, since the battery packs 12a to 12c have different rated output voltages, the battery packs 12a to 12c have different voltages when the battery state of charge rate (%) is the same.

Referring to Fig. 1, each of the battery packs 12a, 12b, and 12c includes an information storage 41. The information storage 41 is configured to provide the main body 11 of the power tool 10 and a charger (not shown) with a signal indicating information on the rated output voltage of the corresponding battery pack 12a, 12b, or 12c. Thus, the control circuit 21 of the main body 11 receives a signal from the information storage 41, and the signal allows for the control circuit 21 to determine whether or not the battery pack 12a, 12b, and 12c is an applicable battery pack. Further, the signal received from the information storage 41 allows for the control circuit 21 to identify which one of the battery packs 12a to 12c is attached to the main body 11.

A voltage measurement unit 23 is connected to the control circuit 21. When one of the battery packs 12a to 12c, which have different voltages, is attached (connected) to the main body 11 of the power tool, the voltage measurement unit 23 measures the voltage of that battery pack.

The control circuit 21 includes a threshold memory 21a. As described above, since the battery packs 12a to 12c have different rated output voltages, the battery packs 12a to 12c have different output voltages when the battery state of charge rate (%) is the same, as shown in Fig. 2. Thus, the threshold memory 21a stores, in advance, a plurality of voltage thresholds respectively associated with the three selectively attached battery packs 12 (12a to 12c) having different voltages. Referring to Fig. 4, the threshold memory 21a stores a voltage threshold Sa1, which indicates the highest state of charge for the battery pack 12a, a voltage threshold Sa2, which indicates a lower state of charge than the state of charge corresponding to the voltage threshold Sa1, and a voltage threshold Sa3, which indicates a lower state of charge than the state of charge corresponding to the voltage threshold Sa2. Accordingly, the voltage threshold Sa1 is greater than the voltage threshold Sa2, and the voltage threshold Sa2 is greater than the voltage threshold Sa3.

The threshold memory 21a also stores a voltage threshold Sb1, which indicates the highest state of charge for the battery pack 12b, a voltage threshold Sb2, which indicates a lower state of charge than the state of charge corresponding to the voltage threshold Sb1, and a voltage threshold Sb3, which indicates a lower state of charge than the state of charge corresponding to the voltage threshold Sb2. Accordingly, the voltage threshold Sb1 is greater than the voltage threshold Sb2, and the voltage threshold Sb2 is greater than the voltage threshold Sb3.

Further, the threshold memory 21a stores a voltage threshold Sc1, which indicates the highest state of charge for the battery pack 12c, a voltage threshold Sc2, which indicates a lower state of charge than the state of charge corresponding to the voltage threshold Sc1, and a voltage threshold Sc3, which indicates a lower state of charge than the state of charge corresponding to the voltage threshold Sc2. Accordingly, the voltage threshold Sc1 is greater than the voltage threshold Sc2, and the voltage threshold Sc2 is greater than the voltage threshold Sc3.

In this example, the battery pack 12a has a smaller rated output voltage than the battery pack 12b, and the battery pack 12b has a smaller rated output voltage than the battery pack 12b. Accordingly, the highest voltage thresholds Sa1, Sb1, and Sc1 respectively set for the battery packs 12a to 12c are set to satisfy Sa1<Sb1<Sc1. In the same manner, the voltage thresholds Sa2, Sb2, and Sc2 are set to satisfy Sa2<Sb2<Sc2. The voltage thresholds Sa3, Sb3, and Sc3 are also set to satisfy Sa3<Sb3<Sc3.

Referring to Figs. 1 and 3, a voltage indicator 24 is connected to the control circuit 21. The voltage indicator 24 includes a plurality of state of charge marks, which are three LEDs 24a to 24c in the present example. The voltage indicator 24 indicates the state of charge (voltage state) of the battery pack 12 with the state of charge marks.

In the power tool 10, when the trigger switch TS is pulled, the control circuit 21 controls the driver 22 and drives the motor M. In this case, the control circuit 21 uses the voltage indicator 24 to indicate the state of charge of the battery pack 12 (one of battery packs 12a to 12c) that is attached to the main body 11 of the power tool 10.

The operation of the power tool 10 will now be described.

The control circuit 21 of the power tool 10 receives a signal indicating information of the rated output voltage from the information storage 41 of the battery pack 12 attached to the main body 11. Based on the signal, the control circuit 21 identifies the battery pack 12 that is attached to the main body 11.

The control circuit 21 measures the present voltage of the battery pack 12 with the voltage measurement unit 23 in predetermined intervals. Further, the control circuit 21 compares the presently measured voltage of the battery pack 12 with the voltage thresholds corresponding to the battery pack 12 attached to the main body 11. More specifically, when the control circuit 21 identifies the battery pack 12a that is attached to the main body 11, the control circuit 21 compares the present voltage of the battery pack 12a with the voltage thresholds Sa1 to Sa3 corresponding to the battery pack 12a. When the control circuit 21 identifies the battery pack 12b that is attached to the main body 11, the control circuit 21 compares the present voltage of the battery pack 12a with the voltage thresholds Sb1 to Sb3 corresponding to the battery pack 12b. When the control circuit 21 identifies the battery pack 12c that is attached to the main body 11, the control circuit 21 compares the present voltage of the battery pack 12a with the voltage thresholds Sc1 to Sc3 corresponding to the battery pack 12c.

When the battery pack 12a having the rated output voltage of 14.4 V is attached to the main body 11, the control circuit 21 compares the voltage thresholds Sa1 to Sa3 stored in the threshold memory 21a with the presently measured voltage of the battery pack 12a. When the present voltage of the battery pack 12a is greater than the voltage threshold Sa1, the control circuit 21 illuminates all of the LEDs 24a to 24c of the voltage indicator 24 shown in Figs. 3 and 4. When the present voltage of the battery pack 12a is smaller than or equal to the voltage threshold Sa1 but greater than the voltage threshold Sa2, the control circuit 21 illuminates the two LEDs 24b and 24c and deactivates the remaining LED 24a in the voltage indicator 24 shown in Figs. 3 and 4. When the present voltage of the battery pack 12a is smaller than or equal to the voltage threshold Sa2 but greater than the voltage threshold Sa3, the control circuit 21 illuminates the LED 24c and deactivates the other LEDs 24a and 24b in the voltage indicator 24. When the present voltage of the battery pack 12a is smaller than or equal to the voltage threshold Sa3, the control circuit 21 flashes the LED 24c and deactivates the other LEDs 24a and 24b in the voltage indicator 24.

When the battery pack 12b having the rated output voltage of 18 V is attached to the main body 11, the control circuit 21 compares the voltage thresholds Sb1 to Sb3 stored in the threshold memory 21a with the presently measured voltage of the battery pack 12b. When the present voltage of the battery pack 12b is greater than the voltage threshold Sb1, the control circuit 21 illuminates all of the LEDs 24a to 24c of the voltage indicator 24 shown in Figs. 3 and 4. When the present voltage of the battery pack 12b is smaller than or equal to the voltage threshold Sb1 but greater than the voltage threshold Sb2, the control circuit 21 illuminates the two LEDs 24b and 24c and deactivates the remaining LED 24a in the voltage indicator 24 shown in Figs. 3 and 4. When the present voltage of the battery pack 12b is smaller than or equal to the voltage threshold Sb2 but greater than the voltage threshold Sb3, the control circuit 21 illuminates the LED 24c and deactivates the other LEDs 24a and 24b in the voltage indicator 24. When the present voltage of the battery pack 12b is smaller than or equal to the voltage threshold Sb3, the control circuit 21 flashes the LED 24c and deactivates the other LEDs 24a and 24b in the voltage indicator 24.

When the battery pack 12c having the rated output voltage of 21.6 V is attached to the main body 11, the control circuit 21 compares the voltage thresholds Sc1 to Sac3 stored in the threshold memory 21a with the presently measured voltage of the battery pack 12c. When the present voltage of the battery pack 12c is greater than the voltage threshold Sc1, the control circuit 21 illuminates all of the LEDs 24a to 24c of the voltage indicator 24 shown in Figs. 3 and 4. When the present voltage of the battery pack 12c is smaller than or equal to the voltage threshold Sc1 but greater than the voltage threshold Sc2, the control circuit 21 illuminates the two LEDs 24b and 24c and deactivates the remaining LED 24a in the voltage indicator 24 shown in Figs. 3 and 4. When the present voltage of the battery pack 12c is smaller than or equal to the voltage threshold Sc2 but greater than the voltage threshold Sc3, the control circuit 21 illuminates the LED 24c and deactivates the other LEDs 24a and 24b in the voltage indicator 24. When the present voltage of the battery pack 12c is smaller than or equal to the voltage threshold Sc3, the control circuit 21 flashes the LED 24c and deactivates the other LEDs 24a and 24b in the voltage indicator 24.

The electric construction tool comprising the battery state indication device as described above has the advantages described below.
(1) The control circuit 21 reads the voltage thresholds corresponding to the identified battery pack 12 from the threshold memory 21a and compares the voltage of the battery pack 12 measured by the voltage measurement unit 23 with the voltage thresholds to determine the state of charge (voltage state) of the battery pack 12. Then, the voltage indicator 24 indicates the state of charge (voltage state) of the battery pack 12 determined by the control circuit 21. Thus, regardless of which one of the three battery packs 12a to 12c having different voltages is selectively attached to the main body 11, the state of charge (voltage state) of the battery pack 12 may be accurately indicated using the voltage thresholds corresponding to the attached one of the battery packs 12a to 12c.
(2) The voltage indicator 24 includes a plurality of state of charge marks. The state of charge of the battery pack 12 is indicated in a stepped manner in accordance with the state of charge (voltage state) of the battery pack 12 determined by the control circuit 21. This allows for accurate indication of the state of charge (battery state) of the battery packs 12a to 12c.

The electric construction tool comprising the battery state indication device as described above uses the three types of battery packs 12a to 12c having different voltages and selectively attached to the main body 11. Instead, there may be only two types of battery packs. Alternatively, there may be four or more types of battery packs. Further, the number of the cells C in each of the battery packs 12a to 12c and the voltage per cell may be changed in accordance with the specification of the power tool.

In the electric construction tool comprising the battery state indication device as described above, the state of charge (voltage state) of the battery pack 12 is indicated in a four-stepped manner. However, it may be indicated in a different manner. Further, as shown in Fig. 4, voltage thresholds Sa4, Sb4, and Sc4 that are smaller than the voltage thresholds Sa3, Sb3, and Sc3 may be set for the battery packs 12a to 12c, respectively. When the voltage of the battery pack 12 is smaller than the corresponding one of the voltage thresholds Sa4, Sb4, and Sc4, the main body 11 of the power tool 10 may be deactivated.

In the electric construction tool comprising the battery state indication device as described above, the state of charge (voltage state) of the battery pack 12 is indicated by the number of illuminated LEDs. However, the state of charge (voltage state) may be indicated through other means. For example, a numerical value may be used to indicate the state of charge (voltage state). Alternatively, a voice or sound may be used to indicate the state of charge (voltage state). The electric construction tool comprising the battery state indication device as described above may be a power tool which may be used as a drill driver, an impact driver, an impact wrench, a hammer drive, a vibration drill, a jigsaw, a sealing gun, or the like. The electric construction tool comprising the battery state indication device as described above is not limited to a power tool and may be, for example, a construction light, a construction cleansing device (cleaner or blower), or the like.

The present details of the above description are to be considered as illustrative and not restrictive, and the invention is not to be limited to the details given herein but defined by the appended claims.

## Claims

1. An electric construction tool, comprising:
a battery state indication device;
**characterized in that** the battery state indication device is selectively connectable to one of a plurality of battery packs (12a to 12c) configured to have different rated output voltages and **in that** the battery state indication device comprises:
a voltage measurement unit (23) configured to, when one of the plurality of battery packs (12a to 12c) is connected to the battery state indication device, measure a voltage of the battery connected to the battery state indication device;
a battery identification unit (21) configured to identify the one of the battery packs (12a to 12c) connected to the battery state indication device;
a threshold memory (21a) configured to store a plurality of voltage thresholds (Sa1 to Sa3, Sb1 to Sb3, and Sc1 to Sc3) respectively corresponding to the rated output voltages of the battery packs (12a to 12c) and respectively indicating different states of charge for the battery packs (12a to 12c), wherein the rated output voltage of each of the battery packs (12a to 12c) is defined in accordance with the total number of series-connected cells included in the respective battery pack (12a to 12c) and the voltage per cell;
a control unit (21) configured to read the voltage thresholds corresponding to the rated output voltage of the battery pack identified by the battery identification unit (21) and configured to compare the voltage of the battery pack (12) measured by the voltage measurement unit (23) with the voltage thresholds corresponding to the identified battery pack (12) to determine a state of charge of the battery pack (12); and
an indicator (24) configured to indicate the state of charge of the battery pack determined by the control unit (21),
wherein the indicator (24) includes a plurality of state of charge marks (24a to 24c); and
in accordance with the state of charge of the battery pack (12) determined by the control unit (21), the indicator (24) is configured to indicate the state of charge of the battery pack (12) in a stepped manner with the state of charge marks (24a to 24c),
wherein the state of charge marks (24a to 24c) include a plurality of LEDs; and
the control unit (21) is configured to determine the number of LEDs that are illuminated based on the comparison of the measured voltage of the battery pack (12) with the voltage thresholds, and
wherein the control unit (21) is further configured to receive a signal indicating information on the rated output voltage from the battery pack (12) and determine whether or not the battery pack (12) is a battery pack applicable to the electric construction tool based on the received signal.

2. The electric construction tool device according to claim 1, being **characterized in that**:
the state of charge marks (24a to 24c) include three LEDs;
the voltage thresholds corresponding to each of the battery packs (12a to 12c) include a first voltage threshold, a second voltage threshold that is smaller than the first voltage threshold, and a third voltage threshold that is smaller than the second voltage threshold; and
the control unit (21) is configured to illuminate all of the three LEDs when the measured voltage of the battery pack (12) is greater than the first voltage threshold;
the control unit (21) is configured to illuminate two of the three LEDs when the measured voltage of the battery pack (12) is smaller than or equal to the first voltage threshold but greater than the second voltage threshold;
the control unit (21) is configured to illuminate one of the three LEDs when the measured voltage of the battery pack (12) is smaller than or equal to the second voltage threshold but greater than the third voltage threshold; and
the control unit (21) is configured to flash one of the three LEDs when the measured voltage of the battery pack (12) is smaller than or equal to the third voltage threshold.

3. The electric construction tool according to any one of claims 1 and 2, being **characterized in that**:
the threshold memory (21a) is configured to store a plurality of threshold values (Sa1 to Sa3) corresponding to a first battery pack (12a), and a plurality of threshold values (Sb1 to Sb3) corresponding to a second battery pack (12b) of which the output voltage differs from the first battery pack (12a); and
the voltage thresholds (Sa1 to Sa3) corresponding to the first battery pack (12a) differs from the voltage thresholds (Sb1 to Sb3) corresponding to the second battery pack (12b).

## Patentansprüche

1. Elektrisches Bauwerkzeug, das Folgendes umfasst:
eine Batteriezustandsanzeigevorrichtung,
**dadurch gekennzeichnet, dass** die Batteriezustandsanzeigevorrichtung wahlweise an einen von mehreren Batteriesätzen (12a bis 12c) anschließbar ist, die so konfiguriert sind, dass sie eine unterschiedliche Nennausgangsspannung haben, und dass die Batteriezustandsanzeigevorrichtung Folgendes umfasst:
eine Spannungsmesseinheit (23), die so konfiguriert ist, dass sie, wenn einer der mehreren Batteriesätze (12a bis 12c) an die Batteriezustandsanzeigevorrichtung angeschlossen ist, eine Spannung der an die Batteriezustandsanzeigevorrichtung angeschlossenen Batterie misst,
eine Batterieerkennungseinheit (21), die so konfiguriert ist, dass sie den einen der an die Batteriezustandsanzeigevorrichtung angeschlossenen Batteriesätze (12a bis 12c) erkennt,
einen Grenzwertspeicher (21a), der so konfiguriert ist, dass er mehrere Spannungsgrenzwerte (Sa1 bis Sa3, Sb1 bis Sb3 und Sc1 bis Sc3) speichert, die jeweils der Nennausgangsspannung der Batteriesätze (12a bis 12c) entsprechen und jeweils unterschiedliche Ladezustände für die Batteriesätze (12a bis 12c) anzeigen, wobei die Nennausgangsspannung jedes der Batteriesätze (12a bis 12c) gemäß der Gesamtanzahl von in dem jeweiligen Batteriesatz (12a bis 12c) in Reihe geschalteten Zellen und der Spannung pro Zelle definiert ist,
eine Steuereinheit (21), die so konfiguriert ist, dass sie die Spannungsgrenzwerte ausliest, die der Nennausgangsspannung des von der Batterieerkennungseinheit (21) erkannten Batteriesatzes entsprechen, und so konfiguriert ist, dass sie die von der Spannungsmesseinheit (23) gemessene Spannung des Batteriesatzes (12) mit den Spannungsgrenzwerten vergleicht, die dem erkannten Batteriesatz (12) entsprechen, und so einen Ladezustand des Batteriesatzes (12) bestimmt, und
eine Anzeige (24), die so konfiguriert ist, dass sie den von der Steuereinheit (21) bestimmten Ladezustand des Batteriesatzes anzeigt,
wobei die Anzeige (24) mehrere Ladezustandsmarkierungen (24a bis 24c) aufweist und
wobei die Anzeige (24) so konfiguriert ist, dass sie gemäß dem von der Steuereinheit (21) bestimmten Ladezustand des Batteriesatzes (12) den Ladezustand des Batteriesatzes (12) mit den Ladezustandsmarkierungen (24a bis 24c) stufenweise anzeigt,
wobei die Ladezustandsmarkierungen (24a bis 24c) mehrere LEDs aufweisen und
wobei die Steuereinheit (21) so konfiguriert ist, dass sie auf der Grundlage des Vergleichs der gemessenen Spannung des Batteriesatzes (12) mit den Spannungsgrenzwerten die Anzahl der aufleuchtenden LEDs bestimmt, und
wobei die Steuereinheit (21) ferner so konfiguriert ist, dass sie ein Signal empfängt, das Informationen zur Nennausgangsspannung aus dem Batteriesatz (12) anzeigt, und auf der Grundlage des empfangenen Signals bestimmt, ob es sich bei dem Batteriesatz (12) um einen für das elektrische Bauwerkzeug geeigneten Batteriesatz handelt.

2. Elektrisches Bauwerkzeug nach Anspruch 1, **dadurch gekennzeichnet, dass**:
die Ladezustandsmarkierungen (24a bis 24c) drei LEDs aufweisen,
zu jedem der den Batteriesätzen (12a bis 12c) entsprechenden Spannungsgrenzwerten ein erster Spannungsgrenzwert, ein unter dem ersten Spannungsgrenzwert liegender zweiter Spannungsgrenzwert und ein unter dem zweiten Spannungsgrenzwert liegender dritter Spannungsgrenzwert gehört und
die Steuereinheit (21) so konfiguriert ist, dass sie alle drei LEDs aufleuchten lässt, wenn die gemessene Spannung des Batteriesatzes (12) über dem ersten Spannungsgrenzwert liegt,
die Steuereinheit (21) so konfiguriert ist, dass sie zwei der drei LEDs aufleuchten lässt, wenn die gemessene Spannung des Batteriesatzes (12) unter dem ersten Spannungsgrenzwert liegt oder diesem entspricht, aber über dem zweiten Spannungsgrenzwert liegt,
die Steuereinheit (21) so konfiguriert ist, dass sie eine der drei LEDs aufleuchten lässt, wenn die gemessene Spannung des Batteriesatzes (12) unter dem zweiten Spannungsgrenzwert liegt oder diesem entspricht, aber über dem dritten Spannungsgrenzwert liegt, und
die Steuereinheit (21) so konfiguriert ist, dass sie eine der drei LEDs aufblinken lässt, wenn die gemessene Spannung des Batteriesatzes (12) unter dem dritten Spannungsgrenzwert liegt oder diesem entspricht.

3. Elektrisches Bauwerkzeug nach einem der Ansprüche 1 und 2, **dadurch gekennzeichnet, dass**:
der Grenzwertspeicher (21a) so konfiguriert ist, dass er mehrere einem ersten Batteriesatz (12a) entsprechende Grenzwerte (Sa1 bis Sa3) und mehrere Grenzwerte (Sb1 bis Sb3) speichert, die einem zweiten Batteriesatz (12b) entsprechen, dessen Ausgangsspannung sich von der des ersten Batteriesatzes (12a) unterscheidet, und
sich die dem ersten Batteriesatz (12a) entsprechenden Spannungsgrenzwerte (Sa1 bis Sa3) von den dem zweiten Batteriesatz (12b) entsprechenden Spannungsgrenzwerten (Sb1 bis Sb3) unterscheiden.

## Revendications

1. Outil électrique de construction, comprenant :
un dispositif d'indication d'état de batterie ;
**caractérisé en ce que** le dispositif d'indication d'état de batterie peut être connecté de manière sélective à l'un d'une pluralité d'blocs de batteries (12a à 12c) configurés pour avoir différentes tensions de sortie assignées et **en ce que** le dispositif d'indication d'état de batterie comprend :
une unité de mesure de tension (23) configurée pour, lorsque l'un de la pluralité d'blocs de batteries (12a à 12c) est connecté au dispositif d'indication d'état de batterie, mesurer une tension de la batterie connectée au dispositif d'indication d'état de batterie ;
une unité d'identification de batterie (21) configurée pour identifier ledit un des blocs de batteries (12a à 12c) connecté au dispositif d'indication d'état de batterie ;
une mémoire de seuils (21a) configurée pour mémoriser une pluralité de seuils de tension (Sa1 à Sa3, Sb1 à Sb3, et Sc1 à Sc3) correspondant respectivement aux tensions de sortie assignées des blocs de batteries (12a à 12c) et indiquant respectivement différents états de charge pour les blocs de batteries (12a à 12c), dans lequel la tension de sortie assignée de chacun des blocs de batteries (12a à 12c) est définie conformément au nombre total de cellules connectées en série incluses dans le bloc de batteries (12a à 12c) respectif et à la tension par cellule ;
une unité de commande (21) configurée pour lire les seuils de tension correspondant à la tension de sortie assignée du bloc de batteries identifié par l'unité d'identification de batterie (21) et configurée pour comparer la tension du bloc de batteries (12) mesurée par l'unité de mesure de tension (23) avec les seuils de tension correspondant au bloc de batteries (12) identifié pour déterminer un état de charge du bloc de batteries (12) ; et
un indicateur (24) configuré pour indiquer l'état de charge du bloc de batteries déterminé par l'unité de commande (21),
dans lequel l'indicateur (24) comprend une pluralité de marques d'état de charge (24a à 24c) ; et
conformément à l'état de charge du bloc de batteries (12) déterminé par l'unité de commande (21), l'indicateur (24) est configuré pour indiquer l'état de charge du bloc de batteries (12) par échelons avec les marques d'état de charge (24a à 24c),
dans lequel les marques d'état de charge (24a à 24c) comprennent une pluralité de DEL ; et
l'unité de commande (21) est configurée pour déterminer le nombre de DEL qui sont allumées sur la base de la comparaison de la tension mesurée du bloc de batteries (12) avec les seuils de tension, et
dans lequel l'unité de commande (21) est en outre configurée pour recevoir un signal indiquant des informations concernant la tension de sortie assignée du bloc de batteries (12) et déterminer si, oui ou non, le bloc de batteries (12) est un bloc de batteries applicable à l'outil électrique de construction sur la base du signal reçu.

2. Dispositif d'outil électrique de construction selon la revendication 1, **caractérisé en ce que** :
les marques d'état de charge (24a à 24c) comprennent trois DEL ;
les seuils de tension correspondant à chacun des blocs de batteries (12a à 12c) comprennent un premier seuil de tension, un deuxième seuil de tension qui est inférieur au premier seuil de tension, et un troisième seuil de tension qui est inférieur au deuxième seuil de tension ; et
l'unité de commande (21) est configurée pour allumer les trois DEL lorsque la tension mesurée du bloc de batteries (12) est supérieure au premier seuil de tension ;
l'unité de commande (21) est configurée pour allumer deux des trois DEL lorsque la tension mesurée du bloc de batteries (12) est inférieure ou égale au premier seuil de tension, mais supérieure au deuxième seuil de tension ;
l'unité de commande (21) est configurée pour allumer l'une des trois DEL lorsque la tension mesurée du bloc de batteries (12) est inférieure ou égale au deuxième seuil de tension, mais supérieure au troisième seuil de tension ; et
l'unité de commande (21) est configurée pour faire clignoter l'une des trois DEL lorsque la tension mesurée du bloc de batteries (12) est inférieure ou égale au troisième seuil de tension.

3. Outil électrique de construction selon l'une quelconque des revendications 1 et 2, **caractérisé en ce que** :
la mémoire de seuils (21a) est configurée pour mémoriser une pluralité de valeurs de seuil (Sa1 à Sa3) correspondant à un premier bloc de batteries (12a), et une pluralité de valeurs de seuil (Sb1 à Sb3) correspondant à un deuxième bloc de batteries (12b) dont la tension de sortie diffère de celle du premier bloc de batteries (12a) ; et
les seuils de tension (Sa1 à Sa3) correspondant au premier bloc de batteries (12a) diffèrent des seuils de tension (Sb1 à Sb3) correspondant au deuxième bloc de batteries (12b).
